(19) Europäisches Patentamt
European Patent Office
Office européen des brevets

(11) EP 0 733 909 B1

(12) **EUROPEAN PATENT SPECIFICATION**

(45) Date of publication and mention of the grant of the patent:
**17.11.2004 Bulletin 2004/47**

(51) Int Cl.[7]: **G01R 31/00**, G01R 19/32

(21) Application number: **96200817.3**

(22) Date of filing: **25.03.1996**

(54) **Method and apparatus for local temperature sensing for use in performing high resolution in-situ measurement**

Methode und Apparat zur lokalen Temperaturmessung für hochauflösende in-situ Messung

Méthode et appareil pour mesurer localement la température pour mesure in-situ avec haute résolution

(84) Designated Contracting States:
**AT BE CH DE DK ES FI FR GB IE IT LI NL SE**

(30) Priority: **24.03.1995 EP 95200747**

(43) Date of publication of application:
**25.09.1996 Bulletin 1996/39**

(73) Proprietors:
- **INTERUNIVERSITAIR MICRO ELEKTRONICA CENTRUM VZW**
  **3030 Leuven-Heverlee (BE)**
- **LIMBURGS UNIVERSITAIR CENTRUM**
  **3590 Diepenbeek (BE)**

(72) Inventors:
- **De Ceuninck, Ward**
  **8580 Avelgem (BE)**
- **Roggen, Jean**
  **3560 Lummen (BE)**
- **Stals, Lambert**
  **3590 Diepenbeek (BE)**
- **De Schepper, Luc**
  **3500 Hasselt (BE)**

(74) Representative:
**Land, Addick Adrianus Gosling et al**
**Arnold & Siedsma,**
**Advocaten en Octrooigemachtigden,**
**Sweelinckplein 1**
**2517 GK Den Haag (NL)**

(56) References cited:

| | |
|---|---|
| **EP-A- 0 049 754** | **EP-A- 0 382 217** |
| **EP-A- 0 395 149** | **EP-A- 0 523 729** |
| **DE-A- 3 212 611** | **US-A- 5 224 775** |

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 733 909 B1

Printed by Jouve, 75001 PARIS (FR)

## Description

The present invention concerns a method and apparatus for measuring a parameter of an electronic component, the measurement being conducted in an oven with heating means at a measurement temperature.

## BACKGROUND OF THE INVENTION

The reliability of electronic components is of crucial importance in modern industry. There is an increasing demand for realistic predictions of the lifetimes of electronic components and of the variation of the components' parameter values over their lifetimes. The components of interest for such parameter predictions include diodes, transistors, passive components such as metalization lines, wire bonds, resistors, capacitors, dielectrics etc.

EP 0 523 729 describes a method for performing a high temperature operating test, wherein the test is conducted at a measurement temperature in an oven with heating means. The junction temperature of the semiconductor chips under test is measured via built-in sensors, and temperature adjusting means adjust the temperature of the oven to keep the junction temperature within a predetermined range.

Another method for predicting the value of a component's ageing parameter over time is to place the component in an environment with a raised temperature, perform a measurement of the parameter, and then repeat the cycle until sufficient measurements are made to permit a reliable prediction of the parameter value over time. However, because of the time required to perform this method it is particularly disadvantageous for systems where a small change of the parameter value occurs.

In EP-A-0395149 an in-situ ageing technique is described, wherein it is possible to measure a component parameter value at an elevated temperature during a relatively short time period, typically on the order of 48 hours. In such a case, it is necessary that the experimental errors in the collected data be minimized if extrapolation of the results to real operating conditions are desired. In this technique, the oven in which the elevated temperature is achieved has a high temperature stability, e.g. on the order of $\pm$ 0,01 °C, or even as small as $\pm$ 0.001 °C.

Such high temperature stability is difficult to achieve and is sometimes accomplished by limiting the physical size of the oven, which generally permits better control of the temperature distribution within the oven. However, a disadvantage of limiting the physical size of the oven is that only one or a few components can be evaluated at the same time.

What is desired is an apparatus and method for obtaining high precision measurements of a component parameter which are corrected for temperature fluctuations occurring in an oven in which the measurements are made.

## SUMMARY OF THE INVENTION

The present invention provides a method according to claim 1.

A temperature coefficient is subsequently used to correct the measured property value and assist in isolating the variation of the measured property over time.

According to a further aspect of the present invention, there is disclosed an oven or furnace in which such reliability tests and parameter measurements can be conducted. It concerns an apparatus according to claim 7.

Further details, advantages and features of the present invention will become clear when reading the following description with reference to the annexed drawings.

## BRIEF DESCRIPTION OF THE DRAWINGS

Fig. 1 is a block diagram of a preferred embodiment of an apparatus for implementing the local temperature sensing and high resolution measurement method of the present invention.

Fig. 2 is a data plot showing the temperature difference and corrected temperature difference for measurements obtained using the apparatus of figure 1.

Fig. 3 is a more detailed representation of the data shown in figure 2.

Fig. 4 is a data plot of uncorrected temperature data obtained using the apparatus of figure 1.

Fig. 5 is a data plot of the measurement results shown in figure 4 after correction using data acquired in accordance with the method of the present invention.

Fig. 6 is a sectional view of a first oven or furnace suitable for use in performing the method of the present invention.

Fig. 7 is a sectional view of a second oven or furnace suitable for use in performing the method of the present invention.

Fig. 8 is a sectional view of a third over or furnace suitable for use in performing the method of the present invention.

Fig. 9 a schematic view of a fourth oven or furnace suitable for use in performing the method of the present invention.

DETAILED DESCRIPTION OF THE INVENTION

Figure 1 is a block diagram of a preferred embodiment of an apparatus for implementing the local temperature sensing and high resolution measurement method of the present invention. In apparatus 1 of the present invention, an electronic component C (labelled "DUT", device under test in the figure) is arranged in a recipient or oven 2 which is provided with heating means 3. Heating means 3 are connected to a control unit 4 to which a first temperature sensor 5 placed inside furnace 2 is connected. Near the component C a second temperature sensor 6 is arranged. Temperature sensor 6 is arranged so as to be in good thermal contact with component C. Component C is connected to a multimeter circuit 7 for measuring the desired ageing parameter or property of the component. Second temperature sensor 6 is connected to a second multimeter circuit 8 for acquisition of data regarding the temperature of the component. Both multimeter circuits 7 and 8 are connected to the same trigger circuit 9, which is also connected to control unit 4. By triggering the multimeter circuits 7 and 8 at the same time, a file with the information (P,T,t) is stored, wherein t is the time of the measurement, T is the temperature measured by second sensor 6, and P is the property of the component measured.

As will be described, this data (P,T,t) is subsequently processed to enhance the stability of the data set. This causes the performance level (in terms of ability to accurately predict the value of the measured parameter over time) of the corrected data set to be better than, or at least comparable to that which can be obtained using a furnace with higher temperature precision (less variation of the temperature inside the oven). The data processing method of the present invention will now be explained.

The temperature dependence of an electrical parameter P, i.e., P(T) can be expressed as:

$$P(T) = P(T^*) \bullet (1+\alpha(T-T^*)) \qquad [1]$$

where $\alpha$ is the temperature coefficient of the component with respect to the measured parameter, T* is the desired temperature at which the parameter value is to be determined, and T is the temperature measured by sensor 6, i.e., the temperature of, or in close proximity to the component palced in the oven.

If a data set ($P_i$,$T_i$) is available, where i = 1..N, then assuming $\alpha$ is know, a corrected data set can be calculated using the following relationship:

$$P^c(T^*) = P(T)/(1+\alpha(T-T^*)) \cong P(T) \bullet (1-\alpha(T-T^*)) \qquad [2]$$

Equation 2 is applicable under the assumption that $\alpha(T-T^*) << 1$ which is the case. Note that this assumption is useful for facilitating the mathematical formulation. $P^c(T^*)$ is the calculated value of P at the desired temperature T*.

The temperature coefficient $\alpha$ can be determined from the (P,t) data by using a minimalization procedure. A number of mathematical methods are suitable for this purpose.

When using the method of Cook, wherein a smoothness parameter S is defined in relation to the calculated data the optimum value of $\alpha$ for maximum smoothness is determined as follows:

$$\alpha = \frac{\Sigma(P_{i+1} - P_i)\cdot(P_{i+1}\Delta T_{i+1} - P_i\Delta T_i)}{\Sigma(P_{i+1}\Delta T_{i+1} - P_i\Delta T_i)^2}$$

$$S = \Sigma\,(P^c_{i+1} - P^c_i)^2$$

Other more complex smoothness parameters can of course be used. By virtue of the above equations, it is shown that the temperature coefficient $\alpha$ can be determined using the measured (P,T) data. It is significant to note that the presence of temperature fluctuations, $\Delta T$, are used to determine the quantity $\alpha$.

The minimalization procedure can be performed on several parts of the data set, and not on the entire (P,T) data set simultaneously. In this way a temperature coefficient ($\alpha$) curve as function of ageing time can be obtained. This information can be introduced in the temperature stability enhancement routine by making $\alpha$ a function of time. This leads to a more complex mathematical formulation than the one above for determining $P^c(T^*)$. This technique will be referred to as the $\Delta$-$\alpha$ deconvolution technique, since it is possible to discriminate between drift of the property values ΔP, and temperature T, characterization during ageing as a result of a single isothermal ageing experiment. Apart from the possibility that changes in the proces occur during ageing, the above technique is also useful for theoretical studies and verification purposes.

It has been shown by the inventors of the present invention that the above described concept further enhances the effective temperature stability of the measured P data. Precision furnace systems make use of multimeters with a temperature read-in resolution of ± 0.0002 °C. When using the above described concept it becomes possible to have an effective temperature stability that equals this amount. However, by using data acquired in accordance with the present invention, it is possible to achieve the noted performance level with a furnace system that has a temperature stability of only ± 0.5 °C. As a result, the inventive concept will reduce costs and make ageing experiments less sensitive to environmental fluctuations of temperature and other parameters.

A further beneficial feature of the described invention is the ability to measure the parameters of a number of components at the same time in a medium precision furnace with high capacity, such as a classic box-oven. Due to the high volume capacity of such a system, it is possible to achieve a high level of temperature stability and/or uniformity for a number of components simultaneously, in a manner comparable to that of a high precision furnace. In such an embodiment of the present invention, every component will be equipped with an individual temperature sensor. Many measurements can be conducted at the same time with a high degree of accuracy, even in the case where the local temperature in the oven varies.

Figure 2 is a data plot showing the temperature difference ΔT and the corrected temperature difference $\Delta T_{corr}$ (expressed in °C) as a function of measured time (expressed in seconds) for measurements obtained using the apparatus of figure 1. The scattered points in the figure represent the temperature as measured at the active zone near a component. As indicated by the spread of the data, a temperature stability of approximately ± 0.05 °C is obtained. The points lying on a flat line (corresponding to a value of 0.00 °C) result from using the previously described algorithm. In figure 3 (and figure 2) it is shown that $\Delta T_{corr}$, i.e., the points lying on a flat line, have an effective temperature stability of approximately ± 0.0005 °C. This value is an improvement by a factor of 100 over the scattered data.

The measurements plotted in figures 2 and 3 were obtained from a box-oil-bath type furnace at a temperature of 75 °C. A Pt 100 resistor was used as the temperature sensor.

An on/of temperature control was used in the box-oil-bath furnace. The temperature stability of the furnace at T=150 °C is on the order of ± 6 °C, and temperature increases at a rate as high as 20 °C/min can occur. After applying the above described temperature correction concept, a temperature stability as high as ± 0.01 °C can be obtained. This result is shown in figure 5. It is noted that the measurements which produced the data shown in figure 5 were conducted in a kettle for preparing French-Fries. The spikes in the data plotted in figure 5 are due to the switch-on characteristics of this kettle and can be removed by using a PID control. Presumably, removal of the data spikes would result in a temperature stability of approximately ± 0.002°C, thereby providing an improvement factor 3000 over the scattered data shown in figure 4.

A gasflow oven 20 (shown in figure 6) which can be used to implement the method of the present invention consists of a double insulated cylindrical metal recipient which is hermetically closed. The oven consists of a cylindrical inner wall 21, an intermediate wall 22 and an outer wall 23 of metal. Between the inner wall 21 and the intermediate wall 22 a layer of insulating compacted mineral powder, e.g. aluminium oxide is disposed. It is noted that other insulation material that is able to withstand the applied range of temperatures can be used. Between intermediate wall 22 and outer wall 23 a further insulating layer is disposed, which allows for arranging a cooling coil 26 therein. The atmosphere in the interior 27 of the oven is gaseous for which purpose a gas inlet 28 and a gas outlet 29 are disposed. The flow rate pressure and composition of the gaseous atmosphere can be varied. The schematically designated component C is provided with connection line(s) 33 which extend through an insulating cap 30 to a control unit 31 for temperature sensing and heating power input. Temperature measurement is performed using not shown platinum resistors (not shown). The temperature regulation is performed by a PID control (not shown), although other control methods and apparatus may be employed. A heating element 32 is wound and fits to the inner wall of the furnace. The spacing between the windings of the heating coil is made small, e.g. about 1 mm, to ensure good thermal coupling between heating element 32 and the surrounding gas atmosphere. A spacing of a few millimeters is provided between heating element 32 and inner wall 21. Heating coil 32 is preferably made of thermocoax type heating wire. The low thermal mass of the heating element and the direct coupling to the surrounding gas provides a fast response to input power changes which is desirable for fast dynamic temperature control. The austenitic steel sheathing of the thermocoax wire is inert against oxygen and water vapor up to 600 °C. Inner wall 21 is preferably fully reflective to enhance thermal insulation. Gas inlet 28 is placed between inner wall 21 and heating coil 32. The gas flow can be controlled externally. Gas outlet 29 is placed inside the space enclosed by heating coil 32. In the example shown, the usable volume of the internal space of the oven is approximately 0.25 liters. Other oven dimensions can be used as long as the design permits a smooth gas flow to achieve equal temperature distribution. In practice the height to width ratio of the oven is chosen to be between 2:1 and 1:1. The temperature can range between room temperature and approximately 500 °C. Using the apparatus shown, a temperature stability of approximately ± 0.001°C at a working temperature of 200°C can be obtained. To allow for lower temperatures than room temperature, the cooling system is used. The cooling temperature needs to be roughly stabilized and the final temperature of the recipient can be controlled through use of the heating element inside. The usable temperature range of this furnace is from -150 °C where liquid nitrogen can be used as medium, to +300 °C or more.

The above described gas flow furnace of figure 6 achieves a high level of temperature stability. The described temperature correction method can be used to enhance the temperature stability even further, up to the limit of the data acquisition capability. It is noted that by using the temperature correction method described, the design of the furnace becomes less critical.

A tube-oil-bath furnace of the type shown in figure 7 can be used to practice the present invention. The furnace of figure 7 makes use of a light thermal mass circulating fluid in a metal recipient or a lightweight oven 41 which is thermally insulated from external influence. In a preferred embodiment, silicon oil was used as fluid, although all other inert and electrical insulating fluids can be used. The bottom of the inner oven 41 is provided with a propeller 42 for circulation of fluid, a temperature sensor 43, and connections 44 and 45 for a heating element 46. Between inner wall 47 and outer wall 48 insulating foam 49 is disposed. The component whose parameter is to be measured (not shown) is introduced into the oven by removing cover 50, which is preferably made of teflon, and upper cover 51. With the tube oil-bath furnace of figure 7, a temperature increase rate of 30°C/min is possible. The cooling down rate is approximately 1 °C per minute. For temperature control a PID control is preferably used. The usable volume of this furnace is approximately 380 cubic mm, while the maximum diameter is approximately 56 mm and the depth approximately 120 mm. The temperature can vary between room temperature and 250°C. The temperature stability is better than ± 0.005 °C at T = 200 °C. The dissipated power is less than 300 watts at 200 °C, and 700 watts during fast heating.

The temperature correction method described above can be used with this type of oven to further enhance the temperature stability up to the limit of the data acquisition resolution method.

A box-oven 80 of the type shown in figure 8 has a large volume and provides for the possibility of measuring the parameters of a number of components simultaneously. Oven 80 consists of an outer wall 81 and an inner wall 82 between which a first insulating layer 83 is disposed. Between the inner wall and the outer wall a further layer 84 of insulating material is arranged. The dimensions of the inner space 85 of oven 80 are approximately cubic to optimize the ratio between oven surface and usable volume. The volume of inner space 85 is approximately 300 liter. Although other insulating material can be employed, in a preferred embodiment the insulating layer consists of a 10 cm thick layer of foam glass which is mounted between the inner and outer walls. The surface of inner wall 82 is heat reflective to reduce heat loss. Oven 80 is provided with a ventilation system 86 to provide continuous gas flow inside the oven volume. Heating of the inner space is provided by four or more electrical heating elements made of thermocoax wire wound to rectangular flat coils. The heating power reaches up to 700 watts (10A at 70V) with a steady-state heating power of about 500 watts at 200°C. The heating element(s) are mounted inside the oven parallel to the inner walls. A distance of a few centimeters between the heating element(s) and inner wall 82 is arranged to permit free air flow. This placement of the heating element(s) yields approximately uniform heating power distribution. The temperature gradient inside the oven is minimized and heat transport is improved by the forced air flow. The oven temperature is measured with a platinum resistor (not shown) located near the center of the oven volume. Temperature data are processed with a digital PID control, preferably having 16 bit resolution or higher. Other temperature controls can also be used.

The usable temperature range of the box type furnace of figure 8 extends from room temperature to 250 °C, while wider temperature ranges are also feasible. With this type of oven a temperature stability of approximately ± 0.05°C is obtained with an overall temperature gradient of 0.2°C. As is known, thermocoax wire consists of Ni/Fe core heating wire coaxial with an austenitic steel sheath and electrically insulated by compacted mineral power. In air, the safe working temperature can reach 600°C.

The box furnace shown in figure 8 provides a medium level of temperature stability. This furnace, however, provides the advantage of being capable of processing a large number of components simultaneously owing to its inner volume.

When the above described temperature correction is used, the temperature stability can be enhanced to a performanced level of approximately ± 0.001 °C, while approximately 100 components can be present in the oven.

A box-type-oil bath furnace 90 of the type shown in figure 9 also has a large inner volume, on the order of more than 4 liters. This allows the measurement of a large number of components at the same time. Oven 90 consists of inner wall 91 and an outer wall 92 between which insulating material 93 (e.g. foam glass) is introduced. Other insulating materials can also be used. Oven 90 is provided with a propeller 95 driven by a motor 94 to provide continuous flow of the fluid inside the oven. In the embodiment of figure 9, heating is provided with metal shielded electrical heating elements 96 located at the bottom of the oven volume. The heating power reaches up to 2000 watts. Heating power is controlled by modulation of power pulse length. A distance of a few centimeters is arranged between heating elements 96 and the oven bottom to enhance fluid circulation. Propeller 95 improves fluid flow and heat transport. The oven temperature is measured with a platinum resistor (not shown) located near the center of the oven volume. Temperature data are processed with a PID control. Other control types can also be employed. The temperature range of the box-oil-bath type furnace of figure 9 is between room temperature and 250 °C, depending among other things on the type of the fluid used. A temperature stability of approximately ± 0.1°C is obtained with a temperature gradient of ± 0.1 °C.

The furnace of figure 9 achieves a medium level of temperature stability. The temperature uniformity is, however good and comparable with the tube-oil-bath system, such as that of the type described. The previously described temperatur correction method can be used to enhance the temperature stability up to a level fully comparable to the other types of ovens. A temperature stability of approximately ± 0.001°C can be achieved with a high number (100 or more) of components being measured simultaneously.

The terms and expressions which have been employed herein are used as terms of description and not of limitation, and there is no intention in the use of such terms and expressions of excluding equivalents of the features shown and described, or portions thereof, it being recognized that various modifications are possible within the scope of the invention claimed.

## Claims

**1.** A method of measuring a parameter, P, of an electronic component (C), the measurement being conducted in an oven (2) with heating means (3) at a measurement temperature, T, **characterized in that** the method comprises:

- measuring the parameter, P, of the component and the measurement temperature, T, at substantially the same time, t; and, using P, T and t as data,
- determining a relationship between the parameter, P, of the component and the measurement temperature , T, based upon fluctuations of the measurement temperature, T, said measurement temperature, T, being measured at substantially the same location as the component.

**2.** The method of claim 1, further comprising determining a corrected or calculated value, $P^c$, of the parameter, P, the sample or component based on the determined relationship between the parameter, P, of the sample or component and the measurement temperature, T.

**3.** The method of claim 1 or 2, wherein the relationship is a temperature coefficient having a substantially linear dependence on temperature.

**4.** The method of claim 1, 2 or 3, wherein the temperature coefficient is determined by using a minimalization procedure.

**5.** The method of claim 3 or 4, wherein the minimalization procedure uses a smoothness parameter.

**6.** The method of claims 3, 4 or 5, wherein a minimalization procedure is performed on one or more parts of a data set obtained from the measurements of the sample or component parameter and the measurement temperature.

**7.** An apparatus (1) for measuring a parameter, P, of an electronic component (C) at a measurement temperature, T, comprising:

- a temperature sensor (6) inside the oven for sensing the measurement temperature near the sample or component;
- first measuring means (8) for measuring the sensed measurement temperature; **characterized in that** the apparatus further comprises:
- second measuring means (7) for measuring the parameter of the sample or component; and
- triggering means (9) for triggering the first and second measuring means (7,8) so as to measure both the measurement temperature, T, and the component parameter, P, thereby obtaining the measurement temperature, T, and parameter measurements, P, at substantially the same time, t whereby, in use, said P, T and t are available as data for subsequent processing.

**8.** The apparatus of claim 7, further comprising:

- means for connecting the triggering means to a control unit (4) and means for determining a relationship between the parameter, P, of the component and the measurement temperature, T, based upon fluctuations of the measurement temperature, T.

**9.** The apparatus of claim 7 or 8, wherein:

- said control unit controlls the heating means; and wherein
- data storage means for storing said data is provided.

**10.** The apparatus of claim 7, 8 or 9, further comprising:

- a plurality of temperature sensors (6) for sensing the temperature of a corresponding number of samples or components.

**11.** The apparatus of any of the claims 7, 8, 9 or 10, wherein the oven (2) is a tube shaped gas flow oven having an inner wall (21), intermediate wall (22), and outer wall (23), and an inner layer of insulating material disposed between the inner (21) and intermediate (22) walls and an outer layer of insulating material disposed between the intermediate (22) and outer (23) walls.

**12.** The apparatus of claim 11, further comprising:

- cooling means (26) disposed in the outer layer of insulating material.

**13.** The apparatus of any of the claims 7-12, wherein the oven is a tube shaped oil bath furnace having circulation means (42) for circulating an oil like fluid.

**14.** The apparatus of any of the claims 7-13, wherein the oven is a box shaped oven (80) having an inner wall (82) and an outer wall (81), and two layers (83, 84) of insulating material disposed between the inner and outer walls and ventilation means (86) for continuous gas flow inside the oven.

**15.** The apparatus of any of the claims 7-13, wherein the oven is a box shaped oven having an inner wall (91) and an outer wall (92), and a layer (93) of insulating material disposed between the inner and outer walls and circulation means (95) for circulating an inert and electrically insulating fluid.

**Patentansprüche**

**1.** Verfahren eines Messens von einem Parameter, P, einer elektronischen Komponente, C, wobei die Messung in einem Ofen (2) mit Heizmitteln (3) bei einer Messungstemperatur, T, durchgeführt wird, **dadurch gekennzeichnet, dass** das Verfahren aufweist:

- Messen des Parameters, P, der Komponente und der Messungstemperatur, T, zum im Wesendlichen gleichen Zeitpunkt, t, und Verwenden von P, T und t als Daten,
- Bestimmen eines Zusammenhangs zwischen dem Parameter, P, der Komponente und der Messungstemperatur, T, basierend auf Fluktuationen der Messungstemperatur, T, wobei die Messungstemperatur, T, am im Wesendlichen gleichen Ort wie die Komponente gemessen wird.

**2.** Verfahren nach Anspruch 1, ferner aufweisend: Bestimmen eines korrigierten oder berechneten Wertes, $P^c$, des Parameters, P, wobei die Probe oder Komponente auf dem bestimmten Zusammenhang zwischen dem Parameter, P, der Probe oder Komponente und der Messungstemperatur, T, basiert.

**3.** Verfahren nach Anspruch 1 oder 2, wobei der Zusammenhang ein Temperaturkoeffizient mit einer im Wesendlichen linearen Abhängigkeit von der Temperatur ist.

**4.** Verfahren nach Anspruch 1, 2 oder 3, wobei der Temperaturkoeffizient durch eine Minimalisationsprozedur bestimmt wird.

**5.** Verfahren nach Anspruch 3 oder 4, wobei die Minimalisationsprozedur einen Glättungsparameter verwendet.

**6.** Verfahren nach Anspruch 3, 4 oder 5, wobei eine Minimalisationsprozedur auf einen oder mehrere Teile eines Datensatzes angewendet wird, der aus den Messungen der Probenoder Komponentenparameter und der Messungstemperatur erlangt wurde.

7. Vorrichtung (1) zum Messen eines Parameters, P, einer elektronischen Komponente, C, bei einer Messungstemperatur, T, aufweisend:

- ... angeordnet ist, wobei der Ofen mit Heizmitteln (3) ausgestattet ist,
- ein Temperatursensor (6) innerhalb des Ofens zum Aufnehmen der Messungstemperatur in der Nähe der Probe oder Komponente,
- erste Messmittel (8) zum Messen der aufgenommenen Temperatur, **dadurch gekennzeichnet, dass** die Vorrichtung ferner aufweist:

- zweite Messmittel (9) zum Messen des Parameters von der Probe oder Komponente, und
- Triggermittel (9) zum Triggern der ersten und zweiten Messmittel (7,8), um sowohl die Messungstemperatur, T, als auch den Komponentenparameter, P, zu messen, wodurch die Messungstemperatur, T, und die Parametermessungen, P, zum im Wesendlichen gleichen Zeitpunkt, t, erlangt werden, wobei bei der Verwendung P, T und t als Daten für eine spätere Verarbeitung verfügbar sind.

8. Vorrichtung nach Anspruch 7, ferner aufweisend:

Mittel zum Verbinden der Triggermittel mit einer Steuerungseinheit (4) und Mittel zum Bestimmen eines Zusammenhangs zwischen dem Parameter, P, der Komponente und der Messungstemperatur, T, basierend auf Fluktuationen der Messungstemperatur, T.

9. Vorrichtung nach Anspruch 7 oder 8, wobei die Steuerungseinheit die Heizmittel steuert und wobei Daten-Speichermittel zum Speichern der Daten vorgesehen sind.

10. Vorrichtung nach Anspruch 7, 8 oder 9, ferner aufweisend:

eine Vielzahl von Temperatursensoren (6) zum Aufnehmen der Temperatur von einer korrespondierenden Anzahl von Proben oder Komponenten.

11. Vorrichtung nach einem der Ansprüche 7, 8, 9 oder 10, wobei der Ofen (2) ein röhrenförmiger Gasfluss-Ofen ist, der eine Innenwand (21), eine Zwischenwand (22) und eine Außenwand (23) aufweist, und wobei eine innere Schicht eines isolierenden Materials zwischen der Innenwand (21) und der Zwischenwand (22) angeordnet ist und eine äußere Schicht eines isolierenden Materials zwischen der Zwischenwand (22) und der Außenwand (23) angeordnet ist.

12. Vorrichtung nach Anspruch 11, ferner aufweisend:

Kühlungsmittel (26), die in der äußeren Schicht des isolierenden Materials angeordnet sind.

13. Vorrichtung nach einem der Ansprüche 7-12, wobei der Ofen ein röhrenförmiger Ölbad-Ofen mit Zirkulationsmitteln (42) zum Zirkulieren eines ölähnlichen Fluids ist.

14. Vorrichtung nach einem der Ansprüche 7-13, wobei der Ofen ein kastenförmiger Ofen (80) mit einer Innenwand (82) und einer Außenwand (81) ist, und wobei zwei Schichten (83, 84) aus isolierendem Material zwischen der Innen- und der Außenwand und Ventilationsmittel (86) für einen kontinuierlichen Gasfluss innerhalb des Ofens angeordnet sind.

15. Vorrichtung nach einem der Ansprüche 7-13, wobei der Ofen ein kastenförmiger Ofen mit einer Innenwand (91) und einer Außenwand (92) ist, und wobei eine Schicht (93) aus isolierendem Material zwischen der Innen- und der Außenwand und Zirkulationsmittel (95) zum Zirkulieren eines inerten und elektrisch isolierenden Fluids angeordnet sind.

**Revendications**

1. Procédé destiné à mesurer un paramètre, P, d'un composant électronique (C), la mesure s'effectuant dans un four (2) avec un moyen de chauffage (3) à une température de mesure, T, **caractérisé en ce que** le procédé comprend les étapes consistant à :

- mesurer le paramètre, P, du composant et la température de mesure, T, à un moment sensiblement identique, t ; et, utiliser P, T et t comme des données,
- déterminer une relation entre le paramètre P, du composant et la température de mesure, T, sur la base des fluctuations de la température de mesure, T, ladite température de mesure, T, étant mesurée à un emplacement sensiblement identique à celui du composant.

**2.** Procédé selon la revendication 1, comprenant en outre, la détermination d'une valeur corrigée ou calculée, Pc, du paramètre, P, l'échantillon ou le composant sur la base de la relation déterminée entre le paramètre, P, de l'échantillon ou du composant et la température de mesure, T.

**3.** Procédé selon la revendication 1 ou 2, dans lequel la relation est un coefficient de température présentant une variation sensiblement linéaire en fonction de la température.

**4.** Procédé selon la revendication 1, 2 ou 3, dans lequel le coefficient des températures est déterminé par l'utilisation d'une procédure de minimalisation.

**5.** Procédé selon la revendication 3 ou 4, dans lequel la procédure de minimalisation utilise un paramètre de lissage.

**6.** Procédé selon la revendication 3, 4 ou 5, dans lequel une procédure de minimalisation est exécutée sur une ou plusieurs parties d'un ensemble de données obtenues grâce aux mesures du paramètre de l'échantillon ou du composant et à la mesure de la température.

**7.** Appareil (1) destiné à mesurer un paramètre, P, d'un composant électronique (C) à une température de mesure, T, comprenant :

- un four dans lequel l'échantillon ou le composant est placé, le four étant équipé d'un moyen de chauffage (3) ;
- un capteur de température (6) à l'intérieur du four destiné à détecter la température de mesure à proximité de l'échantillon ou du composant ;
- un premier moyen de mesure (8) destiné à mesurer la température de mesure détectée ; **caractérisé en ce que** l'appareil comprend en outre :

- un second moyen de mesure (7) destiné à mesurer le paramètre de l'échantillon ou du composant ; et
- un moyen de déclenchement (9) destiné à déclencher le premier et second moyen de mesure (7, 8) afin de mesurer à la fois la température de mesure, T, et le paramètre de composant, P, pour obtenir de ce fait la température de mesure, T, et les mesures de paramètre, P, à un moment sensiblement identique, t, moyennant quoi, à l'usage, lesdits P, T et t sont disponibles en tant que données pour un traitement ultérieur.

**8.** Appareil selon la revendication 7, comprenant en outre :

- un moyen destiné à raccorder le moyen de déclenchement à une unité de commande (4) et un moyen destiné à déterminer une relation entre le paramètre, P, du composant et la température de mesure, T, sur la base des fluctuations de la température de mesure, T.

**9.** Appareil selon la revendication 7 ou 8, dans lequel :

- ladite unité de commande commande le moyen de chauffage ; et dans lequel
- un moyen de stockage des données destiné à stocker lesdites données est prévu.

**10.** Appareil selon la revendication 7, 8 ou 9, comprenant en outre :

- une pluralité de capteurs de température (6) destinés à détecter la température d'un nombre correspondant d'échantillons ou de composants.

**11.** L'appareil selon l'une quelconque des revendications 7, 8, 9 ou 10, dans lequel le four (2) est un four à flux gazeux en forme de tube possédant une paroi interne (21), une paroi intermédiaire (22), et une paroi externe (23), et une couche interne du matériau d'isolation disposé entre les parois internes (21) et intermédiaires (22) et une couche externe d'un matériau d'isolation disposé entre les parois intermédiaires (22) et externes (23).

**12.** Appareil selon la revendication 11, comprenant en outre :

- un moyen de refroidissement (26) disposé sur la couche externe du matériau d'isolation.

**13.** Appareil selon l'une quelconque des revendications 7 à 12, dans lequel le four est une chaudière à bain d'huile en forme de tube possédant un moyen de circulation (42) destiné à faire circuler un fluide identique à de l'huile.

**14.** Appareil selon l'une quelconque des revendications 7 à 13, dans lequel le four est un four (80) en forme de boîte possédant une paroi interne (82) et une paroi externe (81), et deux couches (83, 84) de matériau d'isolation disposées entre les parois internes et externes et un moyen de ventilation (86) pour un flux de gaz continu à l'intérieur du four.

**15.** Appareil selon l'une quelconque des revendications 7 à 13, dans lequel le four est un four en forme de boîte possédant une paroi interne (91) et une paroi externe (92), et une couche (93) des matériaux d'isolation disposés entre les parois internes et externes et le moyen de circulation (95) destiné à faire circuler un fluide inerte et électriquement isolant.

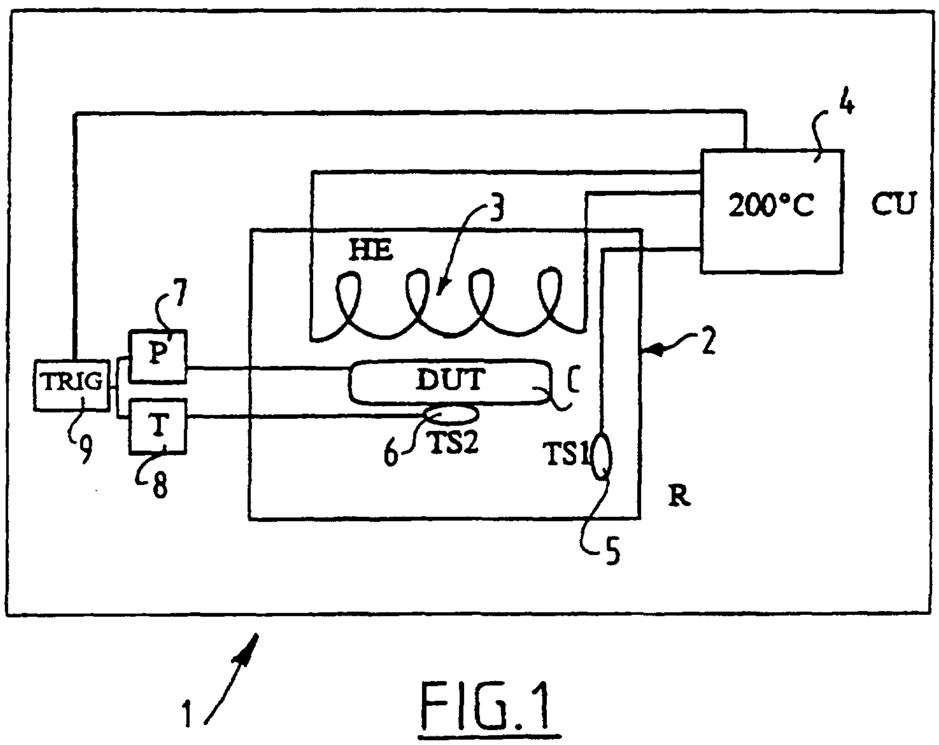


FIG.1

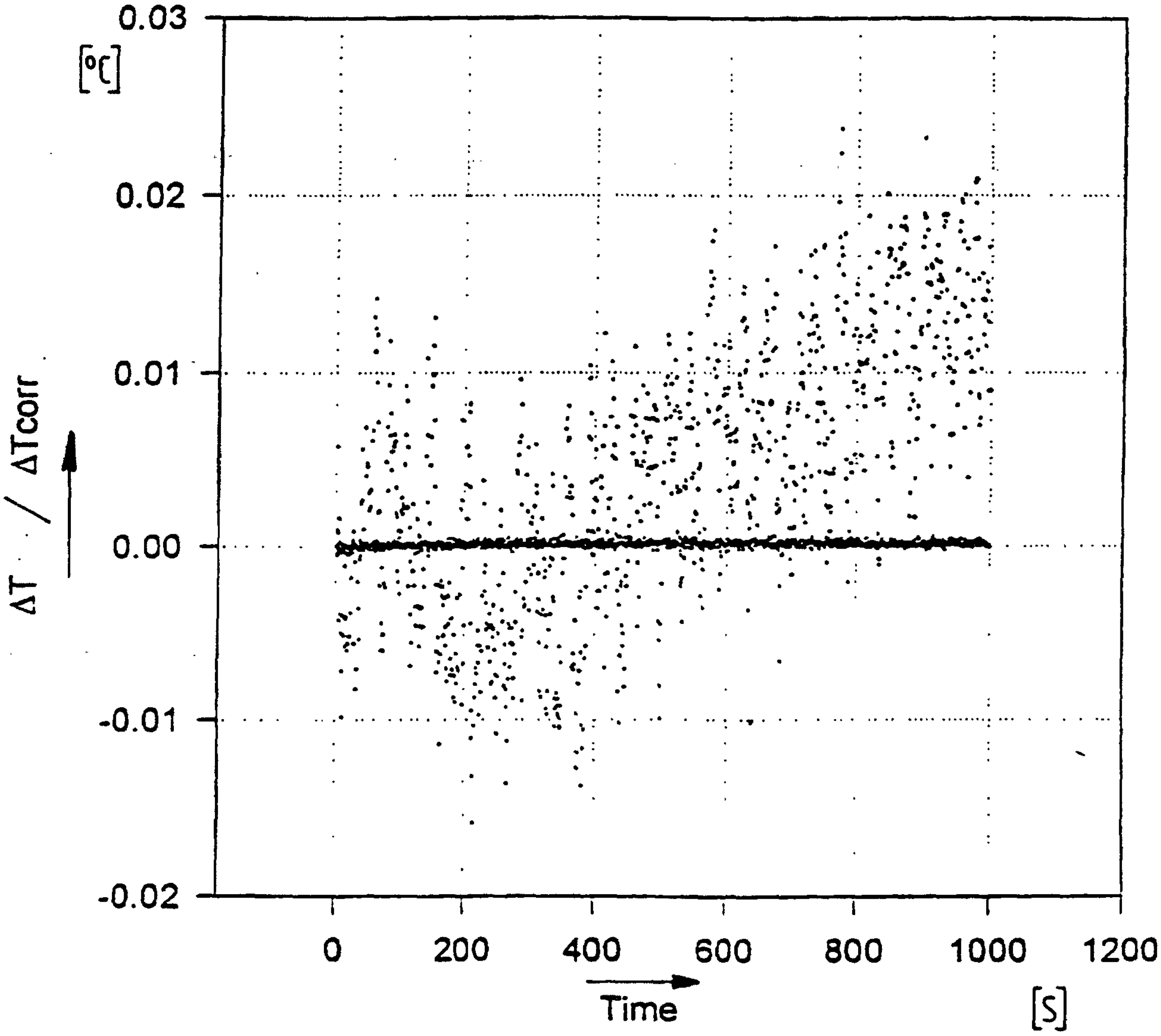
0.03
[°C]
0.02
0.01
0.00
-0.01
-0.02
ΔT / ΔTcorr
0
200
400
600
800
1000
1200
Time
[S]

FIG.2

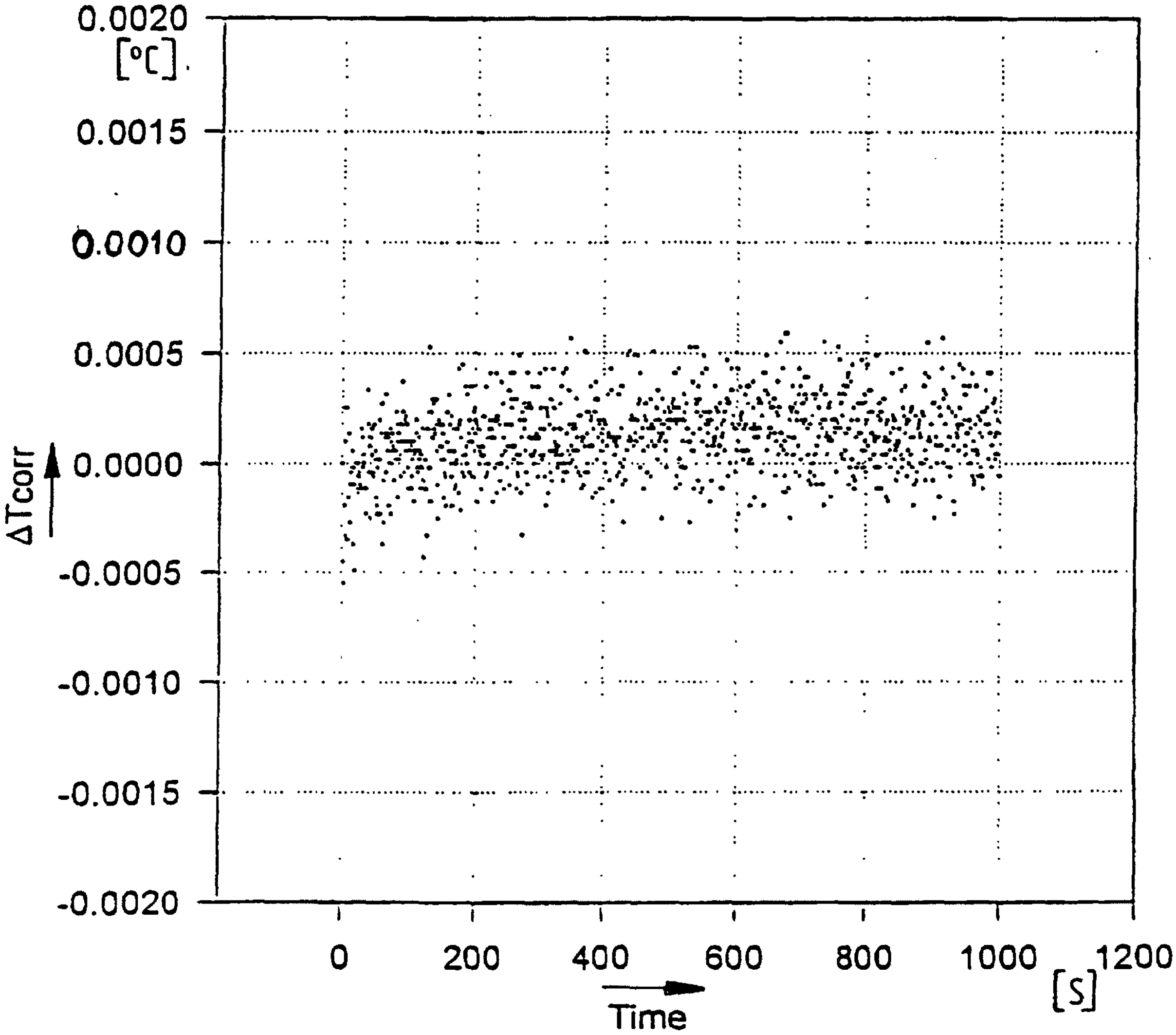
0.0020
[°C]
0.0015
0.0010
0.0005
ΔTcorr
0.0000
-0.0005
-0.0010
-0.0015
-0.0020
0
200
400
600
800
1000
1200
[s]
Time

FIG.3

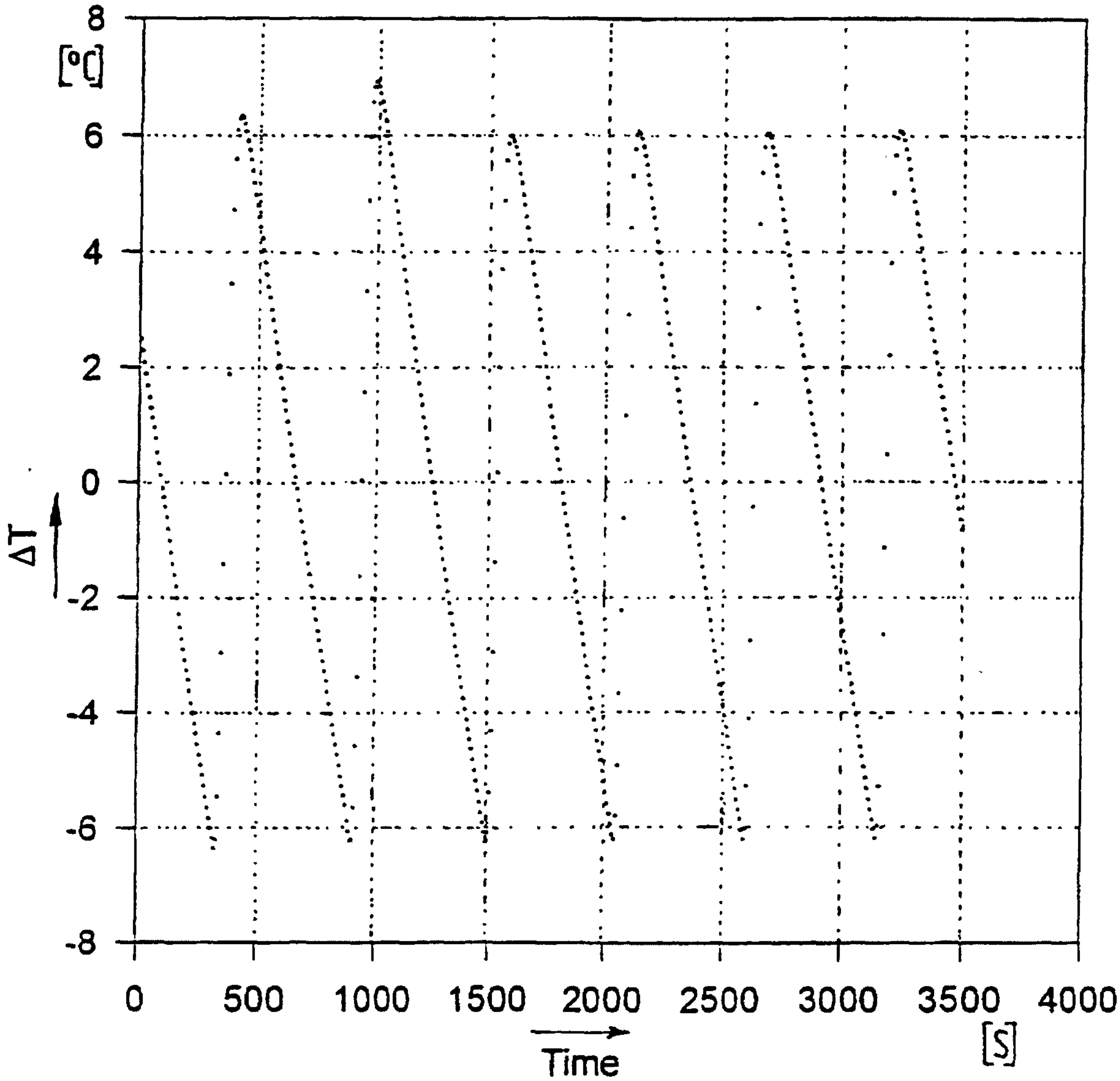


FIG. 4

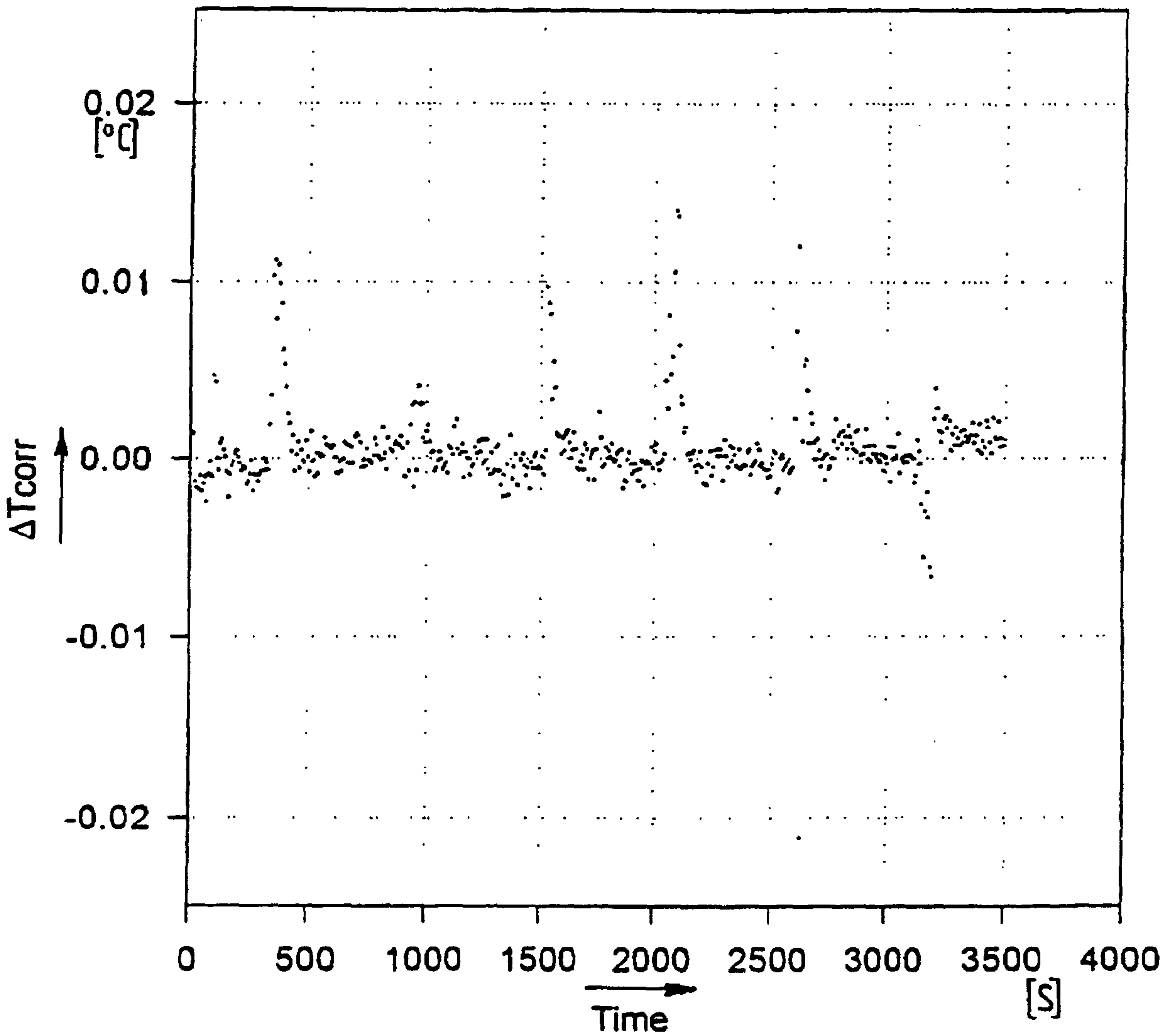
0.02
[°C]
0.01
0.00
-0.01
-0.02
ΔTcorr
0
500
1000
1500
2000
2500
3000
3500
4000
Time
[S]

FIG.5

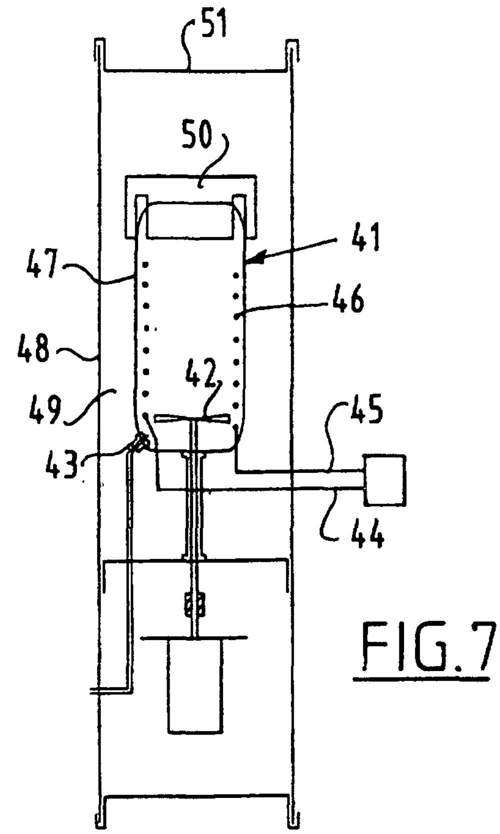
51
50
41
47
46
48
42
49
45
43
44

FIG.7

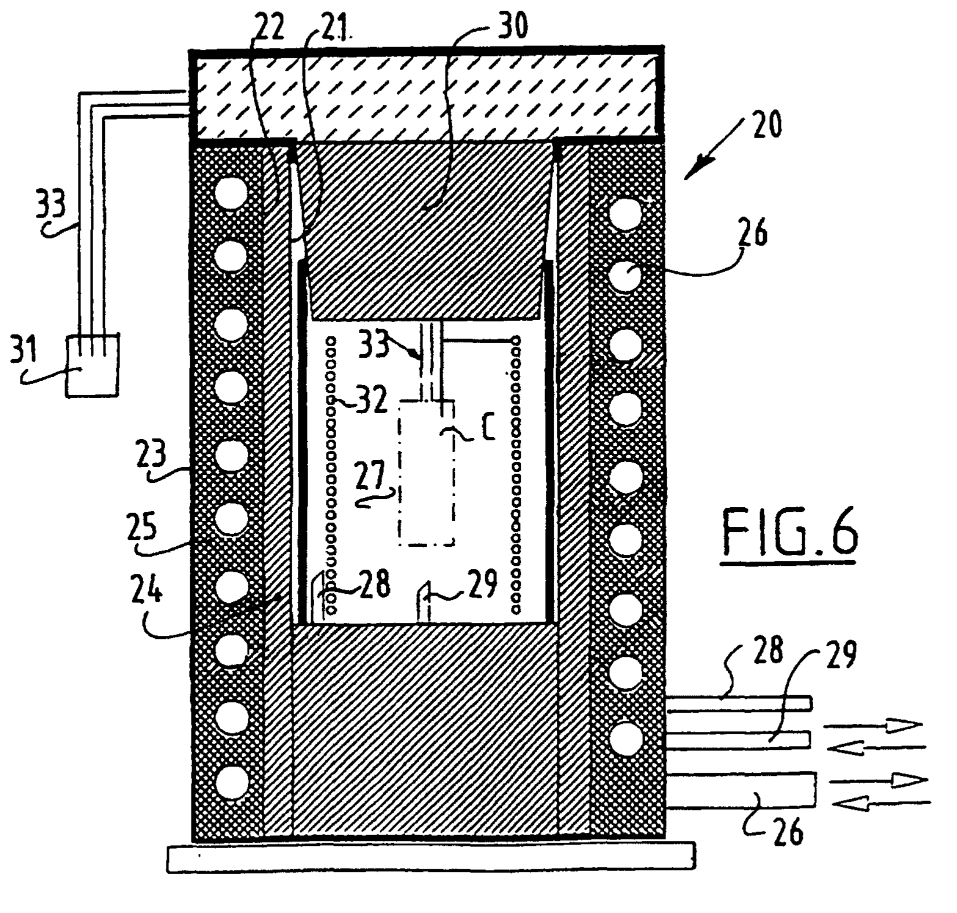
22
21
30
20
33
26
31
33
32
C
23
27
25
24
28
29
28
29
26

FIG.6

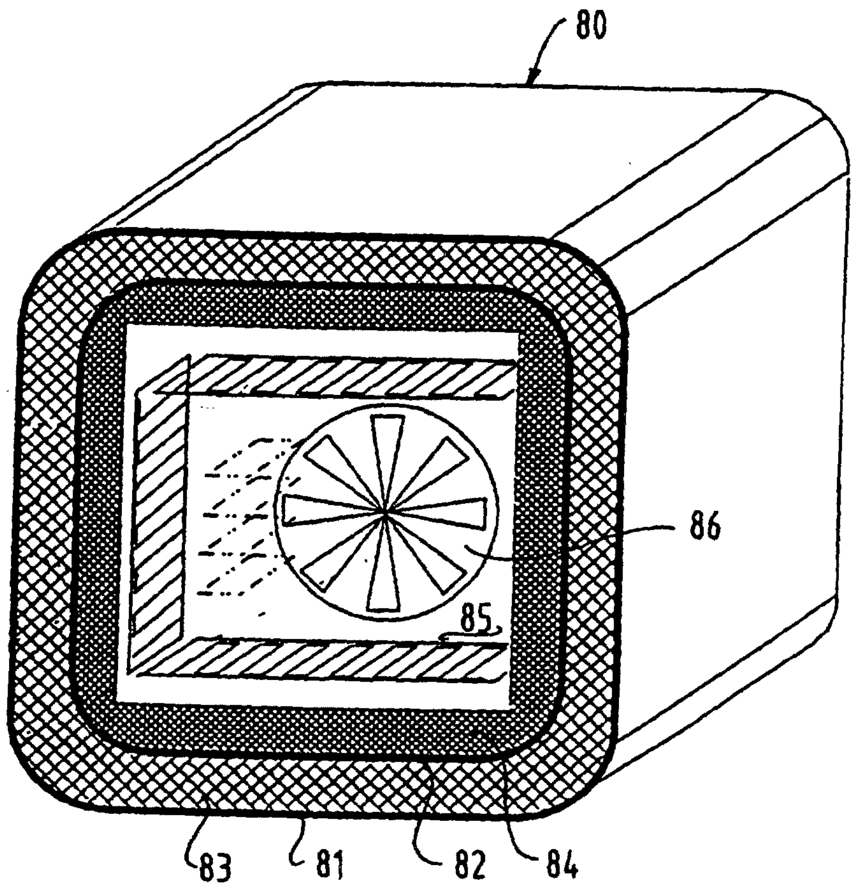


FIG.8

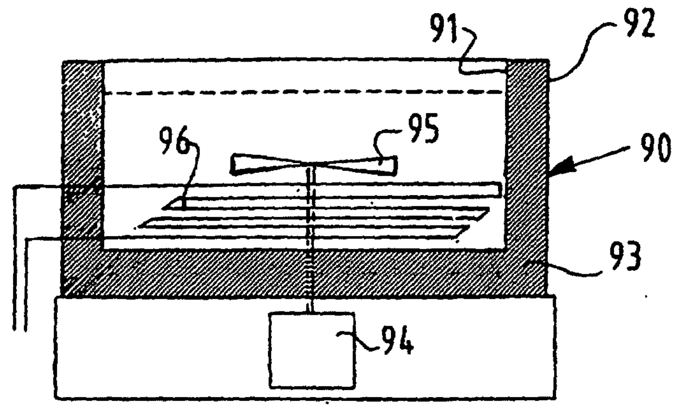


FIG.9